# EUROPEAN PATENT APPLICATION

(11) **EP 4 451 339 A1**
(43) Date of publication of application: **23.10.2024**
(21) Application number: 23214836.1
(22) Date of filing: 07.12.2023
(51) Int. Cl.: H01L 29/08, H01L 29/24, H01L 29/423, H01L 21/34, H01L 29/778, H01L 29/06

(54) **INTEGRATED CIRCUITS WITH MONOLAYER TMD CHANNEL AND MULTILAYER TMD SOURCE AND DRAIN**

(30) Priority: 21.04.2023 US 202318304659
(71) Applicant: INTEL Corporation, Santa Clara, CA 95054 (US)
(72) Inventor: KAVRIK, Mahmut Sami, Eugene, 97405 (US); TRONIC, Tristan A., Aloha, 97003-4278 (US); LUX, Jennifer, Hillsboro, 97124 (US); AVCI, Uygar E., Portland, 97225 (US); O`BRIEN, Kevin P., Portland, 97209 (US)
(74) Representative: Goddar, Heinz J.

(57) **Abstract**

Described herein are transistors with monolayer transition metal dichalcogenides (TMD) semiconductor material. TMD materials include combination of a transition metal (e.g., molybdenum or tungsten) and a chalcogen (e.g., sulfur or selenium) in a monolayer having a hexagonal crystal structure. A transistor has a single layer of TMD forming a channel region, and multiple layers of the TMD material at the source and drain regions. Upper portions of the multilayer TMD source and drain regions are doped, and conductive contacts are formed over the doped portions.

## Description

### Technical Field

This disclosure relates generally to the field of integrated circuit (IC) structures and devices, and more specifically, to transition metal dichalcogenides incorporated in such IC structures and devices.

### Background

Semiconductor materials form the basis of electronic devices, such as diodes and transistors. Recently, new types of semiconductor materials are being explored for use in IC devices. Transition metal dichalcogenides (TMDs) include semiconducting materials formed form a combination of a transition metal (e.g., molybdenum or tungsten) and a chalcogen (e.g., sulfur or selenium) in a monolayer having a hexagonal crystal structure.

In semiconductor fabrication, layers of material are deposited across a wafer having a relatively large area, e.g., 300 mm across. The wafer may be sliced into smaller dies at a later stage. Formation of a monolayer TMD across a large wafer is a challenge for the realization of TMD-based semiconductor devices. Furthermore, it is difficult to form adequately conductive source and drain contacts to a monolayer TMD.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-section showing a transistor having a monolayer TMD channel and multilayer TMD source and drain regions, according to some embodiments of the present disclosure.
FIG. 2 is a flowchart illustrating an example processing method for forming the transistor device shown in FIG. 1, according to some embodiments of the present disclosure.
FIGs. 3A-3H illustrate various steps in the processing method of FIG. 2, according to some embodiments of the present disclosure.
FIG. 4 is a flowchart illustrating a second example processing method for forming the transistor device shown in FIG. 1, according to some embodiments of the present disclosure.
FIGs. 5A-5H illustrate various steps in the processing method of FIG. 4, according to some embodiments of the present disclosure.
FIGS. 6A and 6B are top views of a wafer and dies that include the transistors with monolayer TMD channels and multilayer TMD source and drain regions in accordance with any of the embodiments disclosed herein.
FIG. 7 is a cross-sectional side view of an IC device that may include transistors with monolayer TMD channels and multilayer TMD source and drain regions in accordance with any of the embodiments disclosed herein.
FIG. 8 is a cross-sectional side view of an IC device assembly that may include transistors with monolayer TMD channels and multilayer TMD source and drain regions in accordance with any of the embodiments disclosed herein.
FIG. 9 is a block diagram of an example computing device that may include transistors with monolayer TMD channels and multilayer TMD source and drain regions in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are IC devices that include TMD monolayer channels, and methods for producing such devices. An IC device includes various circuit elements, such as transistors and capacitors, coupled together by conductive materials, such as contacts and interconnects. TMDs are atomically thin materials having the general formula MX₂, where M is a transition metal such as molybdenum (Mo), tungsten (W), or zirconium (Zr), and X is a chalcogen atom (sulfur (S), selenium (Se), or tellurium (Te)). TMDs are very thin, e.g., a MoS₂ monolayer has a thickness of 6.5 angstroms. TMDs that include Mo, W, or Zr as the transition metal are semiconducting. Other TMDs (e.g., TMDs including niobium (Nb), tantalum (Ta), or titanium (Ti)) are conductors.

TMD materials are in the class of two-dimensional materials, also referred to as single-layer materials, such as graphene. Two-dimensional materials are crystalline materials formed from a single material layer, e.g., a single layer of atoms. A single layer of a TMD, also referred to as a monolayer TMD, is composed of three atomic planes: two planes of the chalcogen atoms and one plane of the transition metal atoms. The transition metal (M) atoms are sandwiched between the two layers of the chalcogen (X) atoms.

Semiconductor TMDs have a band gap and electron mobilities similar to those of silicon, making them suitable for transistor fabrication. The electronic properties of monolayer TMDs are highly anisotropic. For example, the conductivity of MoS₂ in the direction parallel to the planar layer is over 2000 times larger than the conductivity perpendicular to the layer. When forming a transistor with a TMD channel, a single layer of a TMD material has superior electrical properties to a channel formed from multiple layers of the TMD material. However, it is difficult to produce a defect-free monolayer TMD across a wide area, e.g., across a wafer.

Furthermore, while the monolayer TMD provides a superior semiconductor channel to a multilayer TMD, it is not feasible to dope a monolayer TMD to create higher-conductivity sources and drains for forming a transistor. Further, as noted above, the conductivity of a monolayer TMD in the direction perpendicular to the layer is low, which makes it difficult to provide a conductive source and drain connection to the monolayer TMD channel.

As described herein, transistor devices having a monolayer TMD channel and multilayer TMD source and drain may overcome the disadvantages of monolayer TMD transistor devices described above. In the devices described herein, the two ends of the transistor (i.e., the source end and drain end) are formed from a multilayer TMD, e.g., a TMD with two, three, four, five, or more layers. An upper portion of the multilayer TMD is doped, e.g., vacancies may be observed in the lattice structure, a different atom may be swapped for a subset of the M or X atoms in the lattice structure, or an additional atom or compound may be introduced outside the lattice structure. Conductive contacts can be formed over these doped source and drain regions.

A monolayer channel is between the multilayer TMD source and drain. The bottom layer of the multilayer TMD source and drain may extend between the source and drain, forming the monolayer TMD channel. A gate dielectric may be formed over the monolayer TMD channel, and a gate electrode over the gate dielectric. The gate dielectric may abut the sides of the source and drain and electrically insulate the source and drain from the gate electrode.

In various embodiments, to form the TMD-based transistors described herein, a multilayer TMD may be grown over a support structure. To form the monolayer channels, in selected regions over the support structure, the upper layers of the multilayer TMD are removed, providing the monolayer TMD channels. The upper layers may be removed in the channel areas using a selective process, such as atomic layer etching or exfoliation. While, as noted above, it is difficult to form a defect-free monolayer TMD across a wide surface area, a multilayer TMD may have fewer defects, particularly in the lowest layer. Thus, the monolayer TMD channels formed using the processes described herein may have fewer defects than monolayer TMD channels formed by depositing a monolayer TMD across a support structure.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

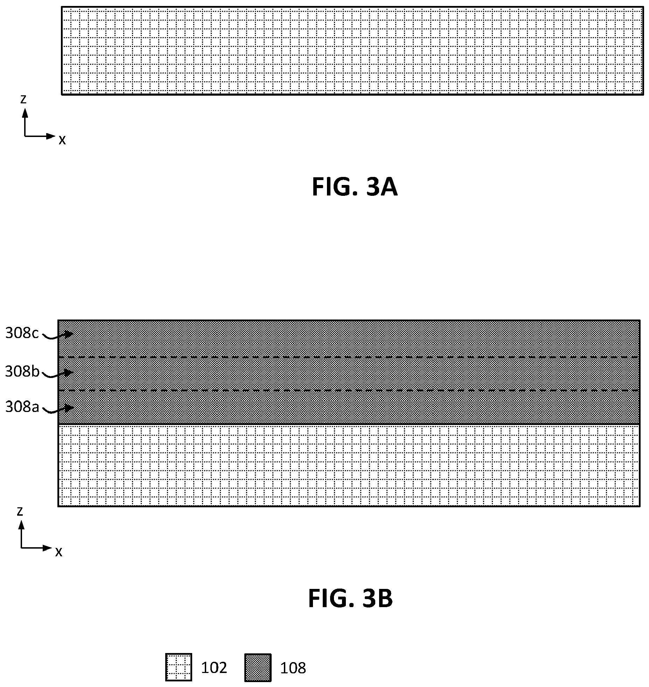

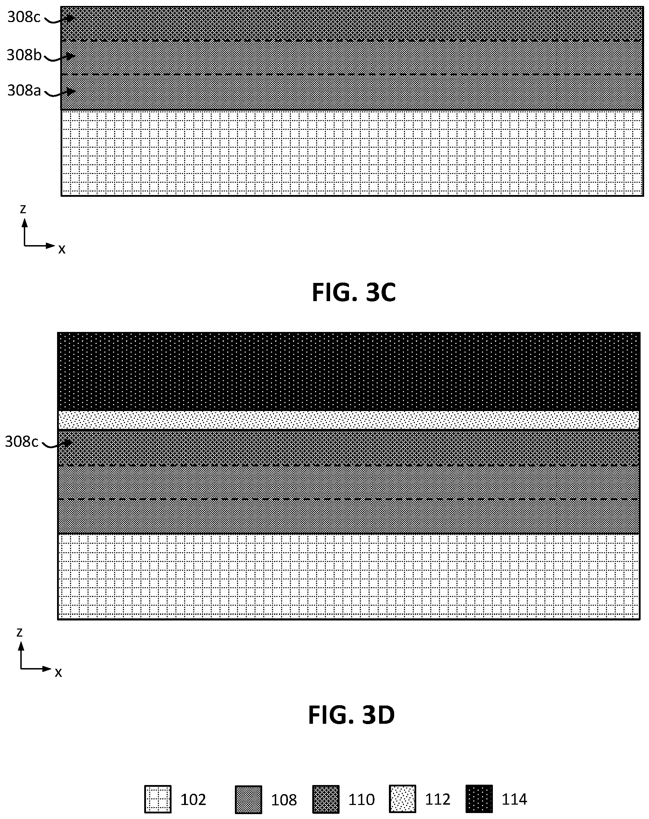

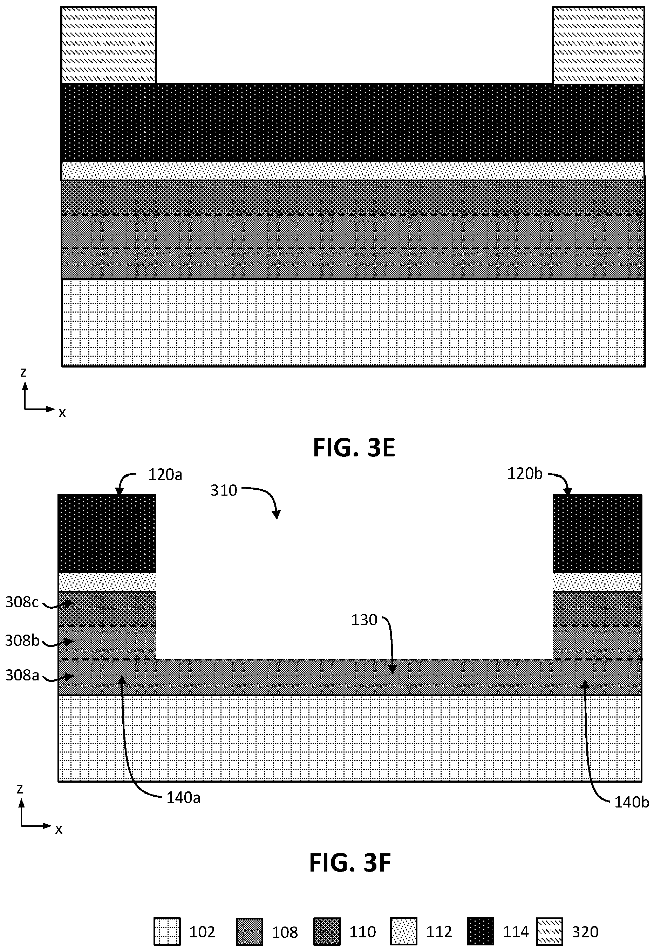

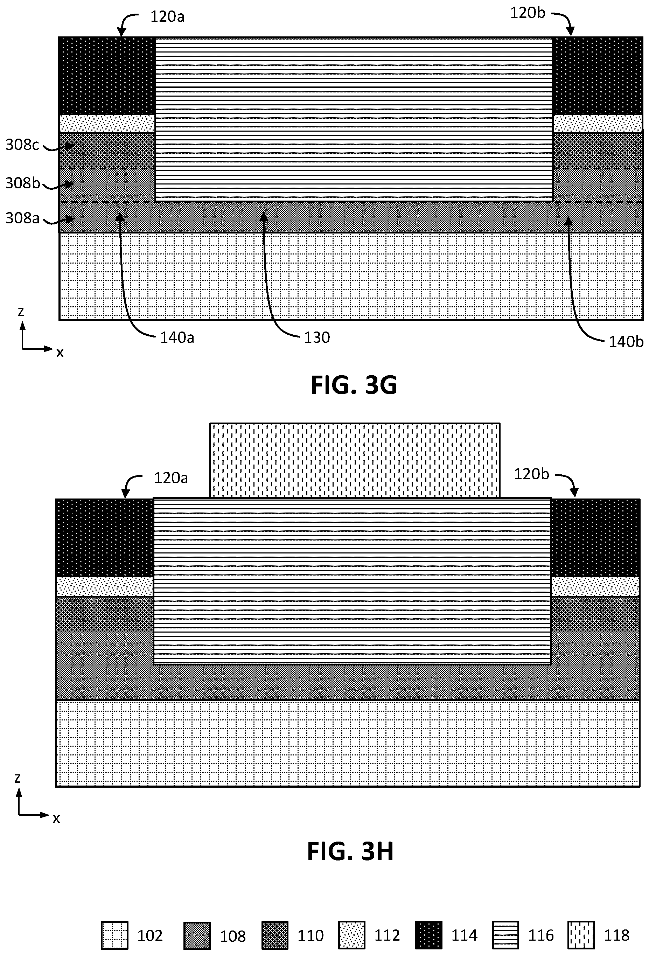

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGSs 3A-3H, such a collection may be referred to herein without the letters, e.g., as "FIG. 3."

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### TMD Transistor Device

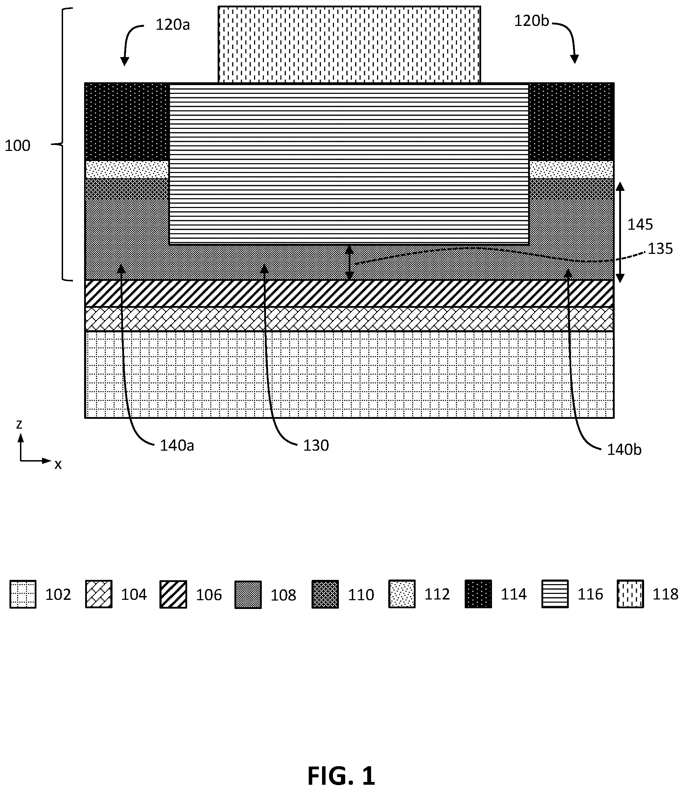

FIG. 1 is a cross-section showing a transistor having a monolayer TMD channel and multilayer TMD source and drain regions, according to some embodiments of the present disclosure.

A number of elements referred to in the description of FIG. 1, FIG. 3, and FIG. 5 with reference numerals are illustrated in these figures with different patterns, with a legend at the bottom of the page showing the correspondence between the reference numerals and patterns. The legend illustrates that FIG. 1 use different patterns to show a support structure 102, a metal interlayer 104, an oxide 106, a TMD channel material 108, a doped TMD material 110, a first metal layer 112, a second metal layer 114, a gate dielectric 116, and a gate electrode 118.

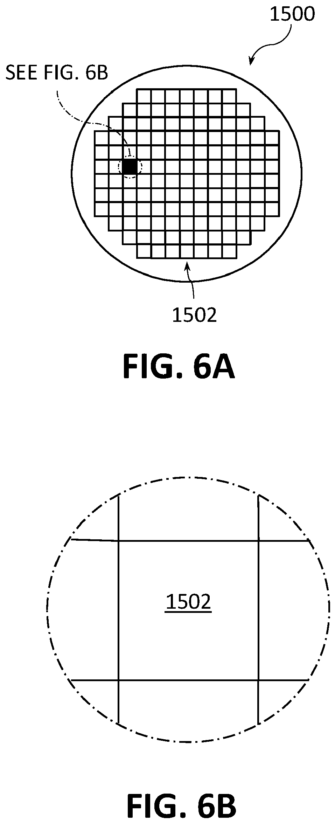

In general, implementations of the present disclosure may be formed or carried out on a support structure, e.g., the support structure 102 illustrated in FIG. 1. The support structure 102 may be, e.g., a substrate, a die, a wafer or a chip. For example, the support structure may be the wafer 1500 of FIG. 6A, discussed below, and may be, or be included in, a die, e.g., the singulated die 1502 of FIG. 6B, discussed below. The support structure 102 extends along the x-y plane in the coordinate system shown in FIG. 1.

In some embodiments, the support structure may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more transistors with monolayer TMD channels, as described herein, may be built falls within the spirit and scope of the present disclosure.

A transistor 100 is formed over the support structure 102. The transistor 100 includes a TMD channel material 108 having a central region 130 and two side regions 140a and 140b. The central region 130 of the TMD channel material 108 is a monolayer TMD channel. As noted above, a monolayer TMD includes one plane of transition metal (M) atoms sandwiched between two planes of a chalcogen atom (X). The transition metal M is a transition metal that forms a semiconductor channel, such as Mo, W, or Zr. The chalcogen X may be selected from S, Se, or Te. Viewed from the top, the M and X atoms are arranged in a hexagonal crystal structure, e.g., each M atom may be covalently bonded to three X atoms in the layer above and three X atoms in the layer below, where the X atoms in the upper and lower layer are aligned. The central region 130 of the TMD channel material 108 has a height 135, which is the height of the monolayer. The height 135 refers to the thickness of the TMD channel material 108 in the central region 130, and the height 135 is a dimension in the z-direction in the coordinate system shown, where the z-direction is perpendicular to the plane of the support structure 102. The height 135 may be, for example, less than 15 angstroms (Å) or less than 10 Å. In some embodiments, the height 135 is between 5 Å and 10 Å.

The side regions 140a and 140b of the TMD channel material 108 are multilayer TMD, e.g., two or more TMD monolayers stacked on top of each other. For example, the side regions 140a and 140b (also referred to as side regions 140) of the TMD channel material 108 may have two, three, four, five, six, or more layers of TMD. The side regions 140 of the TMD channel material 108 have a height 145, which refers to a thickness of the TMD channel material 108 in the side regions 140. The height 145 may be at least two times the height 135 (e.g., if the side regions 140 have two or more TMD layers) or at least three times the height 135 (e.g., if the side regions 140 have three or more TMD layers). The height 145 may be, e.g., at least 10 Å, at least 15 Å, at least 20 Å. In some embodiments, the height 145 is between 10 Å and 30 Å, or between 15 and 40 Å. While the side regions 140a and 140b are illustrated as having the same height 145, in some embodiments, the side regions 140a and 140b have different heights, e.g., the side regions 140a and 140b may include different numbers of layers of TMD.

An upper portion of each of the side regions 140a and 140b of the TMD channel material 108 is doped; these regions are represented in FIG. 1 as the doped TMD material 110. The doped TMD material 110 may include an upper TMD monolayer in each of the side regions 140a and 140b. The doped TMD material 110 includes variations relative to the bulk of the TMD channel material 108, e.g., the structure and/or chemical makeup of the doped TMD material 110 differs from the structure and/or chemical makeup of other portions of the TMD channel material 108. The doped TMD material 110 has different electrical properties from the other portions TMD channel material 108, e.g., increased electrical conductivity.

In some embodiments, the doped TMD material 110 may include vacancies in the lattice structure relative to the TMD channel material 108. For example, while the TMD channel material 108 in the monolayer central region 130 has a consistent hexagonal lattice structure with two X atoms for every M atom, in the doped TMD material 110, some portion of the X atoms or some portion of the M atoms may be removed from the structure.

In other embodiments, in the doped TMD material 110, a different atom may be swapped for a subset of the M or X atoms in the lattice structure. For example, a portion of the M atoms may be replaced with atoms of a different transition metal, e.g., tungsten (W), manganese (Mn), niobium (Nb), iron (Fe), ruthenium (Re), gold (Au), or cobalt (Co). Alternatively, a portion of the X atoms may be replaced with a different atom, e.g., oxygen (O).

In still other embodiments, the lattice structure of the TMD material may be the same as in the TMD channel material 108, but additional atom or compound may be present in the doped TMD material 110 outside the lattice structure. These dopants are referred to as adatoms. The adatoms may be additional M and/or X atoms, e.g., if the TMD material is MoS₂, the doped TMD material 110 may include additional Mo or S atoms outside the lattice structure. The adatoms may be observed at different locations relative to the lattice structure, e.g., above the M atoms, above the X atoms, on an M-X bond, or within or above a hexagonal void. Example adatom dopants may include tungsten (W), manganese (Mn), niobium (Nb), iron (Fe), ruthenium (Re), gold (Au), cobalt (Co), or oxygen (O).

Two source/drain contacts 120a and 120b are formed over the doped regions 110. In this example, the source/drain contacts 120a and 120b include a first metal layer 112 and a second metal layer 114. For example, the first metal layer 112 may be Ru, and the second metal layer 114 may be platinum (Pt). In this example, the first metal layer 112 may increase the electrical conductance of the source/drain contacts 120, e.g., a thin Ru layer increases the durability of a Pt contact. In other embodiments, different metals, metal alloys, or other conductive materials may be used to form the contacts 120. Examples include tungsten, titanium nitride (TiN), and palladium (Pd). In other embodiments, the source and drain contacts 120 may include more or fewer metal layers than illustrated in FIG. 1.

A gate dielectric 116 is formed over the central region 130 of the the TMD channel 108. The gate dielectric 116 is further bounded on the sides by the side regions 140a and 140b of the TMD channel 108 (including the doped TMD material 110) and the source and drain contacts 120a and 120b. In this example, an upper surface of the gate dielectric 116 is in a same plane as an upper surface of each of the source and drain contacts 120a and 120b. In other examples, the gate dielectric 116 may extend higher or lower than the upper surfaces of the source and drain contacts 120a and 120b. The gate dielectric 116 may have a height (a dimension in the z-direction) at least as high as the difference between the heights 145 and 135. In some embodiments, the gate dielectric 116 may have a thickness between 0.5 nanometers and 10 nanometers, including all values and ranges therein, e.g., between 1 and 5 nanometers.

The gate dielectric 116 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 116 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 116 during manufacture of the transistor 100 to improve the quality of the gate dielectric 116.

A gate electrode 118 is formed over the gate dielectric 116. The gate dielectric 116 and gate electrode 118 together form a gate stack. The gate electrode 118 may include at least one P-type work function metal or N-type work function metal. For a PMOS transistor, metals that may be used for the gate electrode 118 may include, but are not limited to, ruthenium, palladium, platinum, cobalt, nickel, and conductive metal oxides (e.g., ruthenium oxide). For an NMOS transistor, metals that may be used for the gate electrode 118 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 118 may include a stack of two or more metal layers, where one or more metal layers are WF metal layers and at least one metal layer is a fill metal layer.

In the example shown in FIG. 1, the transistor 100 is not formed directly over the support structure 102, but instead, is formed over a metal interlayer 104 and an oxide layer 106. The metal interlayer 104 is formed over the support structure 102, and the oxide layer 106 is formed over the metal interlayer 104. The oxide layer 106 may provide electrical insulation (e.g., to the metal interlayer 104 and/or other conductive elements on the other side of the oxide layer 106), and the oxide layer 106 may also provide a suitable surface for growing the TMD channel material 108. The metal interlayer 104 may include, for example, titanium nitride, gold, tungsten, or palladium. The oxide layer 106 may include, for example, hafnium oxide, zirconium oxide, titanium oxide, aluminum oxide, or another oxide.

### Example Process for Forming TMD Transistor Device

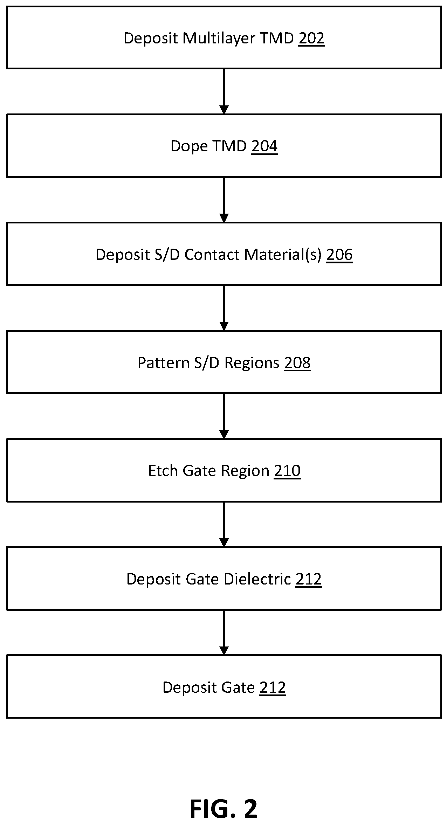

FIG. 2 is a flowchart illustrating an example processing method for forming the transistor device shown in FIG. 1, according to some embodiments of the present disclosure. FIGs. 3A-3H illustrate various steps in the processing method of FIG. 2, according to some embodiments of the present disclosure. In general, the processing method shown in FIG. 2 is performed across a wafer, with many individual transistors formed on the wafer. FIGs. 3A-3H illustrate a cross-section of one example transistor on the wafer.

FIG. 3A illustrates a support structure 102, which may be the same as the support structure 102 illustrated in FIG. 1. While not illustrated in FIGs. 3A-3H, the metal interlayer 104 and oxide layer 106 may be formed over the support structure 102, forming a base for the transistor 100.

At 202, a multilayer TMD is deposited over the support structure 102, e.g., across a full wafer or a portion of a wafer. For example, the TMD channel material 108 is grown over the support structure 102. As noted above, in some embodiments, the TMD channel material 108 is grown on an oxide layer 106 that is over the support structure 102. The TMD channel material 108 may be grown using chemical vapor deposition (CVD), e.g., by vaporizing chemical precursors to the TMD (e.g., a transition-metal oxide containing the M atom, and a pure chalcogen) and exposing the support structure 102 to the vaporized precursors in a heated chamber. In other embodiments, molecular-beam epitaxy (MBE) or electrochemical deposition, also referred to as electrodeposition, may be used. Multiple layers of the TMD channel material 108 are formed. As noted above, depositing multiple layers may provide improved quality of the bottom-most layer (e.g., fewer defects) as opposed to processes in which only a single monolayer is deposited.

FIG. 3B illustrates the TMD channel material 108 over the support structure 102. In this example, three layers 308a, 308b, 308c of the TMD channel material 108 have been grown; boundaries between the layers 308 are indicated by dashed lines.

At 204, an upper region of the TMD channel material 108 is doped, forming the doped TMD material 110. As described with respect to FIG. 1, the upper region may be doped in various ways, e.g., by creating vacancies in the lattice, swapping out a portion of the atoms in the lattice for different atoms, or by adding atoms or compounds outside the of the lattice.

FIG. 3C illustrates the doping of the upper region on of the TMD channel material 108. In this example, the top layer 308c of the channel material 108 has been doped, creating the doped TMD material 110. The middle layer 308b and bottom layer 308a have not been doped.

At 206, the source and drain (S/D) contact materials are deposited. For example, the first metal layer 112 and second metal layer 114 are deposited over the TMD channel material 108, and in particular, over the doped TMD material 110. The S/D contact materials may be deposited over the full wafer or a portion of the wafer. FIG. 3D illustrates the first metal layer 112 and second metal layer 114 having been deposited over the doped TMD material 110.

At 208, the S/D regions are patterned. For example, a photoresist is deposited over the second metal layer 114, e.g., using spin coating. The photoresist is then patterned, which changes a physical property of a portion of the photoresist. For example, a patterned mask may be arranged over the photoresist, and some portions of the photoresist are exposed to patterned actinic radiation through the patterned mask. Some portions of the photoresist (either the exposed portions or the non-exposed portions, depending on the chemistry) can then be removed through a developing process to form openings in the photoresist layer.

FIG. 3E illustrates that the source and drain regions have been patterned using a photoresist, e.g., the source and drain regions are covered by a photoresist 320. A portion of the photoresist 320 between the source and drain regions have been removed in a developing process, as described above.

At 210, a gate region is etched. For example, regions of the wafer that are not covered by the photoresist are etched, forming an open area in which a gate may then be formed. In particular, in the regions that are not covered by the photoresist, the second metal layer 114 and first metal layer 112 are removed, and the doped TMD material 110 is removed. If more than two layers of TMD channel material 108 were deposited, additional layers of the TMD channel material 108 are removed, leaving the monolayer TMD channel 130.

The upper layers of the TMD channel material 108 may be removed using atomic layer etching (ALE). ALE involves performing a sequence that alternates between self-limiting chemical modification steps, each of which affect the top-most atomic layer of the surface, and etching steps which remove the chemically modified areas. Thus, ALE enables removal of individual atomic layers, e.g., individual monolayers of the TMD channel material 108. In alternate embodiments, different etching techniques, such as reactive ion etching, may be used. After the TMD channel material 108 has been etched to expose the bottom-most layer 308a, or at another suitable point in the process, the photoresist 320 may be removed.

FIG. 3F illustrates that an open area 310 for forming the gate region has been etched. This etching exposes the bottom layer 308a of the TMD channel material 108 in the central region 130. The TMD channel material 108 in the central region 130 is a monolayer TMD channel. The etching has also differentiated the two source and drain contacts 120a and 120b, and the two side regions 140a and 140b of the TMD channel material 108. In addition, the photoresist 320 has been removed.

In this example, the TMD channel material 108 includes three layers, 308a, 308b, and 308c. To provide the monolayer TMD channel, the top two layers 308b and 308c were etched, e.g., using ALE. If, as another example, five layers of the TMD channel material were deposited, the upper four layers are removed to provide the monolayer TMD channel.

At 212, a gate dielectric 116 is deposited over the monolayer TMD channel. FIG. 3G illustrates the gate dielectric 116 deposited over the monolayer TMD channel material 108 in the central region 130. The gate dielectric 116 is formed between the side regions 140a and 140b of the TMD channel 108 and, in some embodiments, further between the source and drain contacts formed by the first metal layer 112 and the second metal layer 114. The gate dielectric 116 may be deposited using atomic layer deposition (ALD), which enables precise control when depositing the gate dielectric. Furthermore, ALD and ALE may be performed in the same chamber; depositing the gate dielectric over the monolayer TMD channel without moving the wafer helps protect the exposed monolayer of TMD channel material 108.

At 214, a gate metal 118 is deposited over the gate dielectric 116, thus realizing the transistor 100. The gate metal 118 and gate dielectric 116 form a gate stack. FIG. 3H illustrates that the gate metal 118 has been deposited over the gate dielectric 116. The gate metal 118 may be physically and electrically insulated from the source and drain contacts 120a and 120b. For example, an additional dielectric material (not illustrated in the figures) may separate the source and drain contacts 120a and 120b from the gate metal 118. Various metal layers providing interconnects to the gate metal 118 and the source and drain contacts 120a and 120b may be provided to produce an integrated circuit.

### Second Example Process for Forming TMD Transistor Device

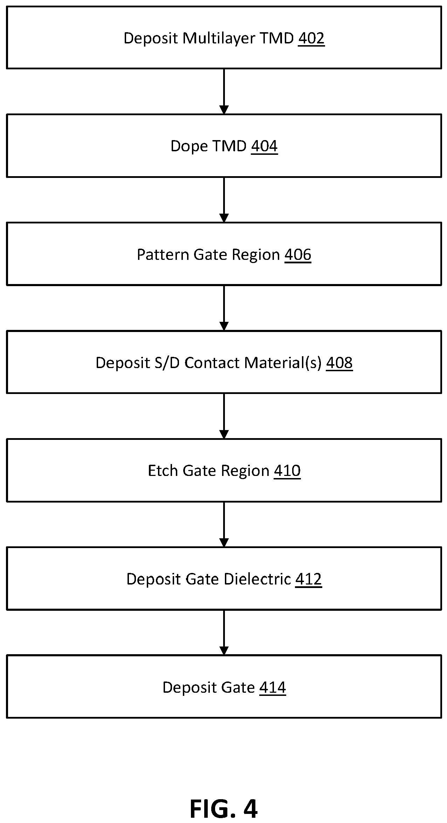

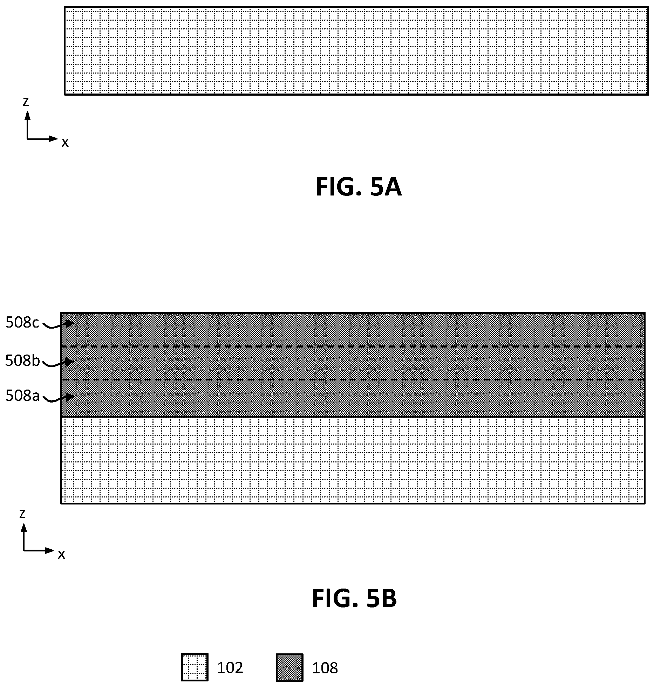

FIG. 4 is a flowchart illustrating a second example processing method for forming the transistor device shown in FIG. 1, according to some embodiments of the present disclosure. FIGs. 5A-5H illustrate various steps in the processing method of FIG. 4, according to some embodiments of the present disclosure. In general, the processing method shown in FIG. 4 is performed across a wafer, with many individual transistors formed on the wafer. FIGs. 5A-5H illustrate a cross-section of one example transistor on the wafer.

FIG. 5A illustrates a support structure 102, which may be the same as the support structure 102 illustrated in FIG. 1. While not illustrated in FIGs. 5A-5H, the metal interlayer 104 and oxide layer 106 may be formed over the support structure 102, forming a base for the transistor 100.

At 402, a multilayer TMD is deposited over the support structure 102, e.g., across a full wafer or a portion of a wafer. The process 402 is similar to the process 202, described above. FIG. 5B illustrates the TMD channel material 108 over the support structure 102. In this example, three layers 508a, 508b, 508c of the TMD channel material 108 have been grown; boundaries between the layers 508 are indicated by dashed lines.

At 404, an upper region of the TMD channel material 108 is doped, forming the doped TMD material 110. As described with respect to FIG. 1, the upper region may be doped in various ways, e.g., by creating vacancies in the lattice, swapping out a portion of the atoms in the lattice for different atoms, or by adding atoms or compounds outside the of the lattice.

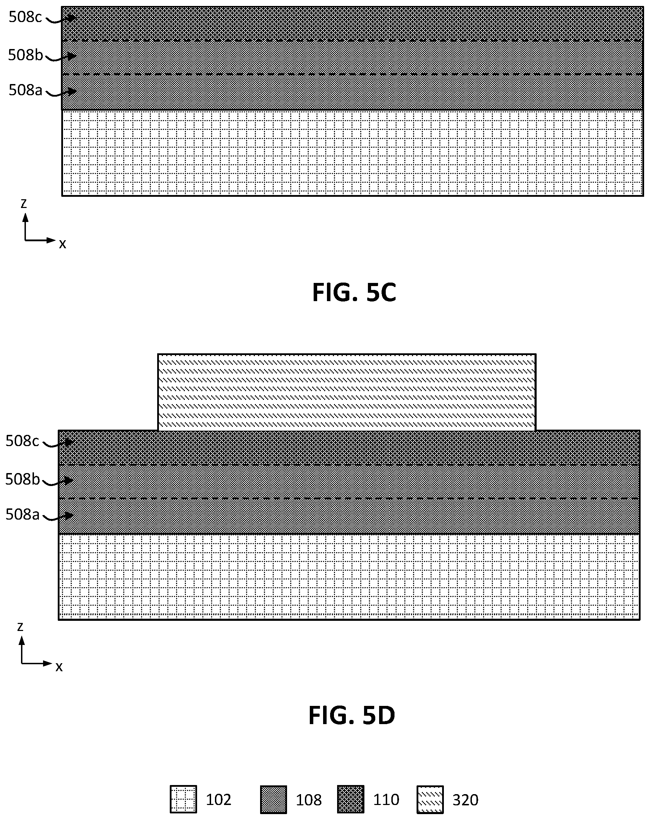

FIG. 5C illustrates the doping of the upper region on of the TMD channel material 108. In this example, the top layer 508c of the channel material 108 has been doped, creating the doped TMD material 110. The middle layer 508b and bottom layer 508a have not been doped.

At 406, a gate region is patterned. For example, a photoresist is deposited over the doped TMD material 110, e.g., using spin coating. The photoresist is then patterned, which changes a physical property of a portion of the photoresist. For example, a patterned mask may be arranged over the photoresist, and some portions of the photoresist are exposed to patterned actinic radiation through the patterned mask. Some portions of the photoresist (either the exposed portions or the non-exposed portions, depending on the chemistry) can then be removed through a developing process to form openings in the photoresist layer.

FIG. 5D illustrates that the gate region (i.e., the region in which the gate is later formed) has been patterned using a photoresist, e.g., the gate region is covered by a photoresist 320. Portions of the photoresist 320 outside the gate region (e.g., portions over the source and drain regions) have been removed in a developing process, as described above.

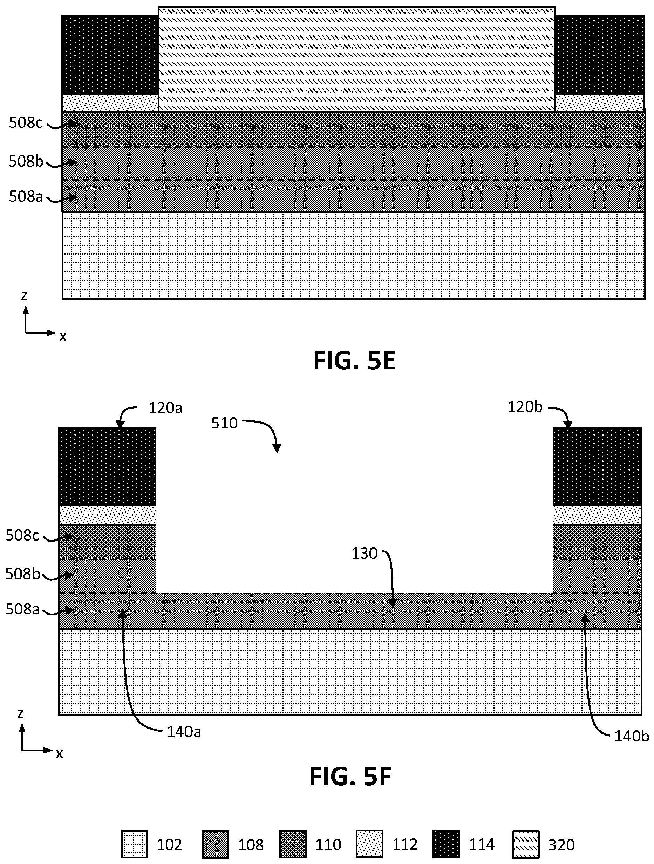

At 408, the source and drain (S/D) contact materials are deposited. For example, the first metal layer 112 and second metal layer 114 are deposited over exposed areas of the TMD channel material 108, and in particular, over exposed areas of the doped TMD material 110. FIG. 5E illustrates the first metal layer 112 and second metal layer 114 having been deposited over the doped TMD material 110.

At 410, a gate region is etched. For example, the photoresist 320 is removed, and one or more layers of the TMD channel material 108 are then removed by etching, forming an open area in which a gate may then be formed. For example, in a first processing step, the photoresist 320 is removed. In a second processing step, in the regions that are not covered by the second metal layer 114 and first metal layer 112, the doped TMD material 110 is removed. If more than two layers of TMD channel material 108 were deposited, additional layers of the TMD channel material 108 are removed, leaving the monolayer TMD channel 130.

The upper layers of the TMD channel material 108 may be removed using atomic layer etching (ALE). ALE involves performing a sequence that alternates between self-limiting chemical modification steps, each of which affect the top atomic layer of the wafer, and etching steps which remove the chemically-modified areas. Thus, ALE enables removal of individual atomic layers, e.g., individual monolayers of the TMD channel material 108. In alternate embodiments, different etching techniques, such as reactive ion etching, may be used. After the TMD channel material 108 has been etched to expose the bottom-most layer 508a, or at another suitable point in the process, the photoresist 320 may be removed.

FIG. 5F illustrates that an open area 510 for forming the gate region has been etched. This etching exposes the bottom layer 508a of the TMD channel material 108 in the central region 130. The TMD channel material 108 in the central region 130 is a monolayer TMD channel. The etching has also differentiated the two source and drain contacts 120a and 120b, and the two side regions 140a and 140b of the TMD channel material 108. In addition, the photoresist 320 has been removed.

In this example, the TMD channel material 108 includes three layers, 508a, 508b, and 508c. To provide the monolayer TMD channel, the top two layers 508b and 508c were etched, e.g., using ALE. If, as another example, five layers of the TMD channel material were deposited, the upper four layers are removed to provide the monolayer TMD channel.

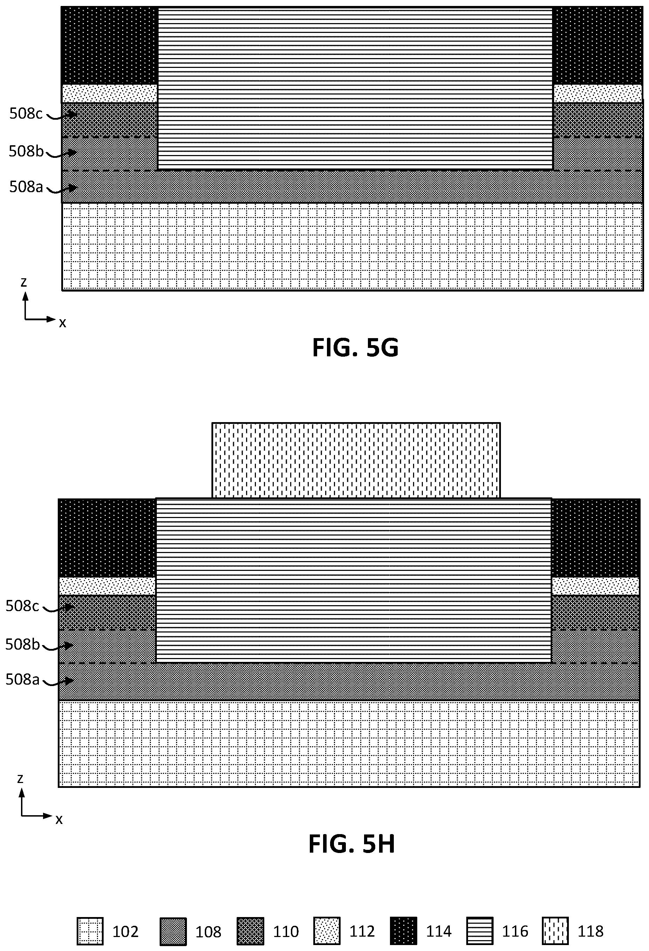

At 412, a gate dielectric 116 is deposited over the monolayer TMD channel. FIG. 5G illustrates the gate dielectric 116 deposited over the monolayer TMD channel material 108 in the central region 130. The process for the gate dielectric 116 is similar to the process 212 described with respect to FIGs. 2 and 3G.

At 414, a gate metal 118 is deposited over the gate dielectric 116, thus realizing the transistor 100. The gate metal 118 and gate dielectric 116 form a gate stack. FIG. 5H illustrates that the gate metal 118 has been deposited over the gate dielectric 116. The process for depositing the gate metal 118 is similar to the process 214 described with respect to FIGs. 2 and 3H.

### Example devices

The transistors with monolayer TMD channels and multilayer TMD source and drain regions disclosed herein may be included in any suitable electronic device. FIGS. 6-9 illustrate various examples of apparatuses that may include the interconnects with barrier material liners disclosed herein.

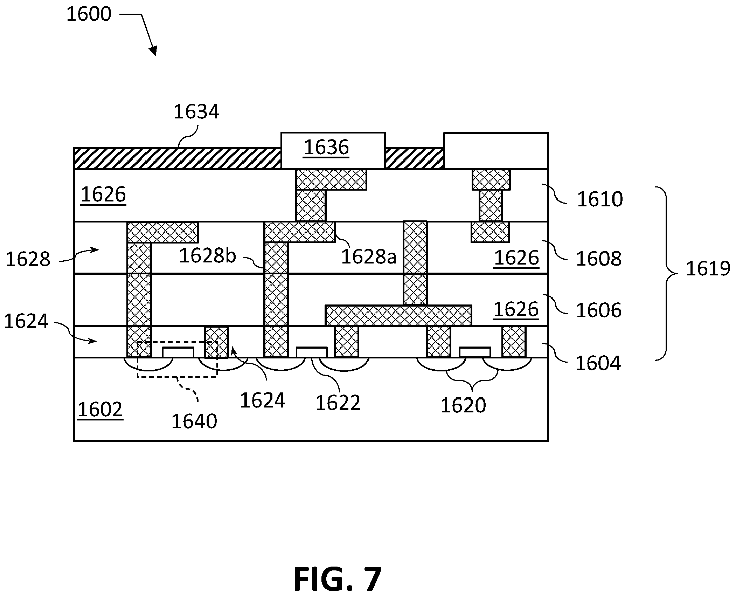

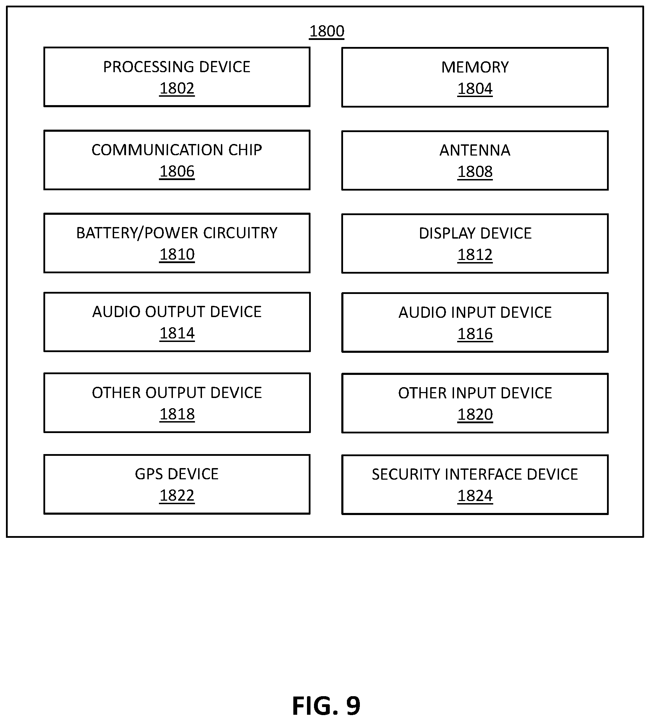

FIG. 6A and 6B are top views of a wafer and dies that include one or more IC structures with one or more transistors with monolayer TMD channels and multilayer TMD source and drain regions in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 1, 3, or 5, or any further embodiments of the IC structures described herein). After the fabrication of the semiconductor product is complete (e.g., after manufacture of one or more IC structures with one or more transistors with monolayer TMD channels and multilayer TMD source and drain regions as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more transistors with monolayer TMD channels and multilayer TMD source and drain regions as disclosed herein may take the form of the wafer 1500 (e.g., not singulated) or the form of the die 1502 (e.g., singulated). The die 1502 may include one or more transistors (e.g., one or more of the transistors 1640 of FIG. 7, discussed below) and/or supporting circuitry to route electrical signals to the transistors, as well as any other IC components (e.g., one or more transistors with monolayer TMD channels and multilayer TMD source and drain regions). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 9) or other logic that is configured to store information in the memory devices or execute instructions stored in the memory array.

FIG. 7 is a cross-sectional side view of an IC device 1600 that may include one or more IC structures with one or more transistors with monolayer TMD channels and multilayer TMD source and drain regions in accordance with any of the embodiments disclosed herein. The IC device 1600 may be formed on a substrate 1602 (e.g., the wafer 1500 of FIG. 6A) and may be included in a die (e.g., the die 1502 of FIG. 6B). The substrate 1602 may be any substrate as described herein. The substrate 1602 may be part of a singulated die (e.g., the dies 1502 of FIG. 6B) or a wafer (e.g., the wafer 1500 of FIG. 6A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 7 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

Although not specifically shown in FIG. 7, the IC device 1600 may include one or more transistors with monolayer TMD channels and multilayer TMD source and drain regions at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 7 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 7). Although a particular number of interconnect layers 1606-1610 is depicted in FIG. 7, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 7. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 7. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

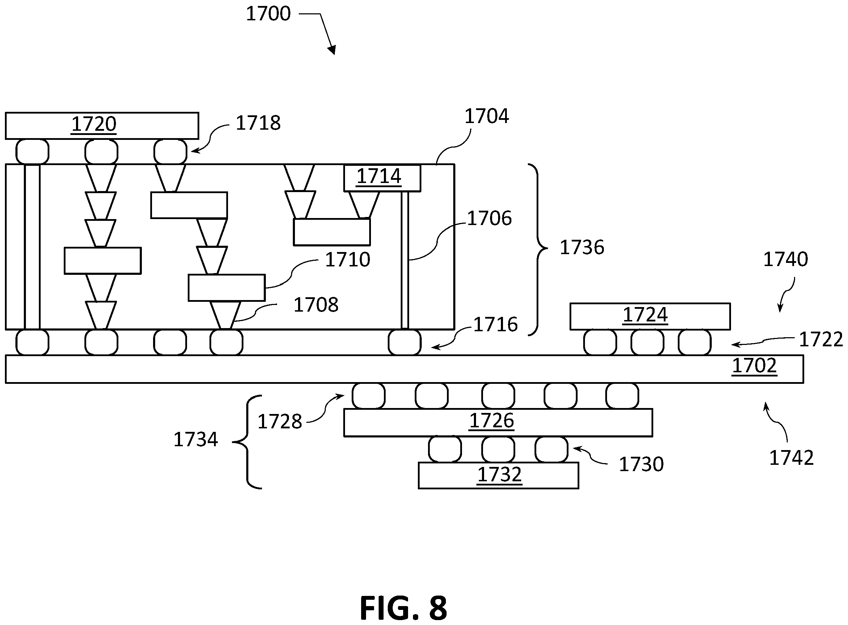

FIG. 8 is a cross-sectional side view of an IC device assembly 1700 that may include components having or being associated with (e.g., being electrically connected by means of) one or more transistors with monolayer TMD channels and multilayer TMD source and drain regions in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include any of the transistors with monolayer TMD channels and multilayer TMD source and drain regions, disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 8 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 8), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 8, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 6B), an IC device (e.g., the IC device 1600 of FIG. 7), or any other suitable component. In some embodiments, the IC package 1720 may include transistors with monolayer TMD channels and multilayer TMD source and drain regions, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 8, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 8 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 9 is a block diagram of an example computing device 1800 that may include one or more components including one or more IC structures with one or more transistors with monolayer TMD channels and multilayer TMD source and drain regions in accordance with any of the embodiments disclosed herein. For example, any suitable ones of the components of the computing device 1800 may include a die (e.g., the die 1502 of FIG. 6B) having transistors with monolayer TMD channels and multilayer TMD source and drain regions as described herein. Any one or more of the components of the computing device 1800 may include, or be included in, an IC device 1600 (FIG. 7). Any one or more of the components of the computing device 1800 may include, or be included in, an IC device assembly 1700 (FIG. 8).

A number of components are illustrated in FIG. 9 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 9, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides transistor device including a TMD over a support structure, the TMD having a central region, a first side region, and a second side region opposite the central region from the first side region, the first side region having a thickness in a direction perpendicular to the support structure at least twice a thickness of the central region; and a dielectric material over the central region of the TMD, the dielectric material between the first side region of the TMD and the second side region of the TMD.

Example 2 provides the transistor device of example 1, further including a metal over the dielectric material.

Example 3 provides the transistor device of example 1 or 2, where the TMD has a lattice structure, and an upper portion of the TMD in the first side region has vacancies in the lattice structure.

Example 4 provides the transistor device of example 1 or 2, where the TMD includes a first transition metal, and an upper portion of the TMD in the first side region further includes a second transition metal different from the first transition metal.

Example 5 provides the transistor device of example 1 or 2, where the TMD includes atoms of a transition metal and atoms of a chalcogen arranged in a lattice structure, and an upper portion of the TMD in the first side region includes additional atoms of the transition metal or the chalcogen outside of the lattice structure.

Example 6 provides the transistor device of any of the preceding examples, further including a metal over the first side region of the TMD and the second side region of the TMD, the metal not over the central region.

Example 7 provides the transistor device of any of the preceding examples, further including a second dielectric material between the support structure and the TMD.

Example 8 provides the transistor device of any of the preceding examples, where the thickness of the central region of the TMD is less than 10 angstroms.

Example 9 provides the transistor device of example 8, where the thickness of the first side region of the TMD is at least three times the thickness of the central region of the TMD.

Example 10 provides the transistor device of any of the preceding examples, where the central region of the TMD is a monolayer.

Example 11 provides the transistor device of any of the preceding examples, where the second side region has a thickness in the direction perpendicular to the support structure at least twice the thickness of the central region.

Example 12 provides a transistor device including a source region including a TMD, wherein an uppermost portion of the TMD in the source region is doped; a drain region including the TMD; and a channel region between the source region and the drain region, the channel region including the TMD.

Example 13 provides the transistor device of example 12, where the source region includes multiple layers of the TMD, and the channel region includes a single layer of the TMD.

Example 14 provides the transistor device of example 13, where the source region and the drain region include a same number of layers of the TMD.

Example 15 provides the transistor device of any of examples 12-14, further including a dielectric over the channel region, the dielectric between the source region and the drain region.

Example 16 provides the transistor device of any of examples 12-15, where the uppermost portion of the TMD in the source region is doped by vacancies in a lattice structure of the TMD.

Example 17 provides the transistor device of any of examples 12-15, where the TMD includes a first transition metal, and the uppermost portion of the TMD in the source region is doped by a second transition metal different from the first transition metal.

Example 18 provides the transistor device of any of examples 12-17, where a thickness of the source region is at least three times a thickness of the channel region.

Example 19 provides a method including depositing multiple layers of a TMD; patterning a portion of the multiple layers of the TMD; etching the patterned portion of the multiple layers of the TMD to provide a region having a single layer of the TMD; and depositing a dielectric material over the region having a single layer of the TMD.

Example 20 provides the method of example 19, further including doping an upper layer of the multiple layers of the TMD.

Example 21 provides the method of example 19 or 20, where the dielectric material is deposited using atomic layer deposition.

Example 22 provides the method of any of examples 19-21, where an atomic layer etch process is used to etch the patterned portion of the multiple layers of the TMD.

Example 23 provides the method of example 22, where the lower-most layer of the multiple layers of the TMD remains following the atomic layer etch process.

Example 24 provides an IC package that includes an IC die, including one or more of the devices according to any one of the preceding examples. The IC package may also include a further component, coupled to the IC die.

Example 25 provides the IC package according to example 24, where the further component is one of a package substrate, a flexible substrate, or an interposer.

Example 26 provides the IC package according to examples 24 or 25, where the further component is coupled to the IC die via one or more first level interconnects.

Example 27 provides the IC package according to example 26, where the one or more first level interconnects include one or more solder bumps, solder posts, or bond wires.

Example 28 provides a computing device that includes a circuit board; and an IC die coupled to the circuit board, where the IC die includes one or more of the memory/IC devices according to any one of the preceding examples (e.g., memory/IC devices according to any one of examples 1-23), and/or the IC die is included in the IC package according to any one of the preceding examples (e.g., the IC package according to any one of examples 24-27).

Example 29 provides the computing device according to example 28, where the computing device is a wearable computing device (e.g., a smart watch) or hand-held computing device (e.g., a mobile phone).

Example 30 provides the computing device according to examples 28 or 29, where the computing device is a server processor.

Example 31 provides the computing device according to examples 28 or 29, where the computing device is a motherboard.

Example 32 provides the computing device according to any one of examples 28-31, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A transistor device comprising:
a transition metal dichalcogenide (TMD) over a support structure, the TMD having a central region, a first side region, and a second side region opposite the central region from the first side region, the first side region having a thickness in a direction perpendicular to the support structure at least twice a thickness of the central region; and
a dielectric material over the central region of the TMD, the dielectric material between the first side region of the TMD and the second side region of the TMD.

2. The transistor device of claim 1, further comprising a metal over the dielectric material.

3. The transistor device of claim 1 or 2, wherein the TMD has a lattice structure, and an upper portion of the TMD in the first side region has vacancies in the lattice structure.

4. The transistor device of claim 1 or 2, wherein the TMD comprises a first transition metal, and an upper portion of the TMD in the first side region further comprises a second transition metal different from the first transition metal.

5. The transistor device of claim 1 or 2, wherein the TMD comprises atoms of a transition metal and atoms of a chalcogen arranged in a lattice structure, and an upper portion of the TMD in the first side region comprises additional atoms of the transition metal or the chalcogen outside of the lattice structure.

6. The transistor device of any of the preceding claims, further comprising a metal over the first side region of the TMD and the second side region of the TMD, the metal not over the central region.

7. The transistor device of any of the preceding claims, further comprising a second dielectric material between the support structure and the TMD.

8. The transistor device of any of the preceding claims, wherein the thickness of the central region of the TMD is less than 10 angstroms.

9. The transistor device of claim 8, wherein the thickness of the first side region of the TMD is at least three times the thickness of the central region of the TMD.

10. The transistor device of any of the preceding claims, wherein the central region of the TMD is a monolayer.

11. The transistor device of any of the preceding claims, wherein the second side region has a thickness in the direction perpendicular to the support structure at least twice the thickness of the central region.

12. The transistor device of any of the preceding claims, wherein the first side region comprises multiple layers of the TMD.

13. A method comprising:
depositing multiple layers of a transition metal dichalcogenide (TMD);
patterning a portion of the multiple layers of the TMD;
etching the patterned portion of the multiple layers of the TMD to provide a region having a single layer of the TMD; and
depositing a dielectric material over the region having a single layer of the TMD.

14. The method of claim 13, further comprising:
doping an upper layer of the multiple layers of the TMD.

15. The method of claim 13 or 14, wherein an atomic layer etch process is used to etch the patterned portion of the multiple layers of the TMD.
